# EUROPEAN PATENT APPLICATION

(11) **EP 4 826 401 A1**
(43) Date of publication of application: **21.10.2026**
(21) Application number: 25751032.1
(22) Date of filing: 07.01.2025
(51) Int. Cl.: G01R 31/367, G01R 31/392

(54) **BATTERY CELL OPEN-CIRCUIT VOLTAGE DETECTION METHOD BASED ON GAUSSIAN MIXTURE MODEL**

(30) Priority: 08.02.2024 CN 202410175574
(71) Applicant: Hefei Gotion High-Tech Power Energy Co., Ltd., Hefei, Anhui 230012 (CN)
(72) Inventor: WEI, Wenxu, Hefei, Anhui 230012 (CN); XU, Jiawen, Hefei, Anhui 230012 (CN); PENG, Chang, Hefei, Anhui 230012 (CN)
(74) Representative: karo IP
(86) International application number: PCT/CN2025/070908
(87) International publication number: WO 2025/167430

(57) **Abstract**

This application discloses a method for detecting an open-circuit voltage of a battery cell based on a Gaussian mixture model, and belongs to the field of battery detection. The method includes: collecting an open-circuit voltage dataset that includes a time stamp, a battery cell number, and an open-circuit voltage value; performing denoising and normalization preprocessing on the collected open-circuit voltage dataset; constructing, based on an expectation-maximization (EM) algorithm, a Gaussian mixture model by using the preprocessed open-circuit voltage dataset; and performing open-circuit voltage anomaly detection by using the constructed Gaussian mixture model. To resolve the problem of low open-circuit voltage detection precision in the prior art, this application constructs the Gaussian mixture model based on the EM algorithm, and optimizes model parameters by iteratively performing an E-step and an M-step. By using the model, anomaly detection can be performed on the open-circuit voltage of the battery cell, and dynamic adjustment of the number of model components and incremental learning are supported to adapt to system changes. By calculating responsibilities of the data and setting a threshold, an anomaly of the open-circuit voltage of the battery cell can be efficiently and accurately determined, thereby improving the detection precision of the open-circuit voltage.

## Description

### TECHNICAL FIELD

This application relates to the field of battery detection, and in particular, to a method for detecting an open-circuit voltage of a battery cell based on a Gaussian mixture model.

### BACKGROUND

An open-circuit voltage (OCV) of a battery cell of a battery is one of the important indicators for evaluating a health status and performance of a battery, and directly affects quality and safety of the battery cell. Existing anomaly detection on the OCV of the battery cell is mainly performed on a tray-by-tray basis. This needs to centrally analyze and determine open-circuit voltages (OCVs) of a plurality of battery cells in each tray. However, in practical application, the number of battery cells in each tray varies significantly, ranging from single digits to dozens, and the statistical distribution of the open-circuit voltages (OCVs) is also complex. A conventional detection method is difficult to adapt to variations in the number of battery cells and complex distributions, easily causing false alarms or missed alarms.

The Chinese Patent Application No. CN202210904863.6, published on July 29, 2022, discloses an abnormal battery box detection method based on a depth autoencoder Gaussian mixture distribution, and belongs to the technical field of energy storage power station security. The method includes: obtaining to-be-tested characteristic data of the battery box, where the to-be-tested characteristic data represents current performance of the battery box; based on a pre-obtained depth autoencoder Gaussian mixture distribution model, determining a corresponding distribution probability based on the to-be-tested characteristic data, where the depth autoencoder Gaussian mixture distribution model is obtained by training historical characteristic data of the battery box, and the historical characteristic data and the to-be-tested characteristic data are the same in data type; and determining, based on the distribution probability, whether the battery box is an abnormal battery box. However, in this solution, the Gaussian mixture distribution has good fitting performance for single-mode data, but has a weak capability for describing a complex multimodal distribution. Therefore, detection precision of this solution needs to be further improved.

### SUMMARY

### 1. Technical problem to be solved

To solve the problem of low precision in detecting an open-circuit voltage in the prior art, this application provides a method for detecting an open-circuit voltage of a battery cell based on a Gaussian mixture model, thereby improving the open-circuit voltage detection precision by constructing the Gaussian mixture model based on an expectation-maximization (EM) algorithm.

### 2. Technical solutions

The objectives of this application are achieved by the following technical solutions.

An embodiment of this specification provides a method for detecting an open-circuit voltage of a battery cell based on a Gaussian mixture model. The method includes: collecting an open-circuit voltage dataset that includes a time stamp, a battery cell number, and an open-circuit voltage value; performing denoising and normalization preprocessing on the collected open-circuit voltage dataset; constructing, based on an expectation-maximization (EM) algorithm, a Gaussian mixture model by using the preprocessed open-circuit voltage dataset; and performing anomaly detection on open-circuit voltage data by using the constructed Gaussian mixture model.

A device for collecting an open-circuit voltage of a battery cell is provided, for example, hardware such as a data acquisition card and a data line. A collection program is compiled to scan and measure an open-circuit voltage value of each battery cell at a specific time interval. The collection program simultaneously reads a system time as a time stamp, and records a unique number of a corresponding battery cell. During each scan, a group of data including a time stamp, a battery cell number, and a corresponding open-circuit voltage value is recorded, thereby finally forming the open-circuit voltage dataset. The dataset may be stored in a local database or uploaded to a cloud database. A sampling frequency of the open-circuit voltage may be set, for example, collection is performed every 10 minutes. An instantaneous open-circuit voltage during charging and discharging may also be collected. Other information such as a brand, a model, and a usage duration of the battery cell may be further recorded as auxiliary information of the dataset. During data collection, denoising may be performed to remove obviously erroneous data. A storage format of the collected dataset may be a standard format such as csv, xlsx, or json. The dataset provides an input source for subsequent open-circuit voltage analysis, modeling, and anomaly detection.

The collected open-circuit voltage dataset is denoised through algorithms such as median filtering and mean filtering to remove an outlier noise point. Normalization, for example, min-max normalization, is performed on the dataset to map the data to a comparable scale for ease of comparison. A Gaussian mixture model is constructed, based on the expectation-maximization (EM) algorithm, by using the preprocessed dataset. The number of Gaussian components may be preset, and model parameters may be learned by iteratively performing an E-step and an M-step. In the E-step, a responsibility of each data point with respect to each Gaussian component is calculated. In the M-step, the model parameters are updated based on the responsibilities. An iteration termination condition is set, to obtain final model parameters including a mean, a covariance matrix, and a mixing coefficient. Anomaly detection is performed on new data by using the constructed Gaussian mixture model, and responsibilities are calculated and compared with a threshold for determination. When new data that does not conform to an existing mode appears, the model parameters may be incrementally adjusted for continued learning. The expression capability of the model may also be extended by adding or removing Gaussian components. Finally, an abnormal data result is output to locate an abnormal battery cell. A model performance evaluation procedure may be established to continuously optimize the model and the parameter.

Further, constructing the Gaussian mixture model includes: presetting the number H of components of the Gaussian mixture model, and initializing a mean, a variance, and a mixing coefficient of each Gaussian component i, where the number H of components represents the number of Gaussian components included in the Gaussian mixture model; iteratively performing an E-step and an M-step on the preprocessed open-circuit voltage dataset, where in the E-step, a responsibility of each piece of open-circuit voltage data with respect to each Gaussian component i is calculated; and in the M-step, parameters of each Gaussian component i are updated based on the responsibility obtained in the E-step; and setting a threshold of a responsibility change and a maximum iteration count, and repeating the E-step and the M-step until the responsibility change is less than the preset threshold or the preset maximum iteration count is reached.

A Gaussian component refers to each Gaussian distribution component included in the Gaussian mixture model. In this application, the Gaussian mixture model includes a plurality of Gaussian components, and each Gaussian component is used to describe one mode or cluster in the data. The preset number H of components indicates that the model includes H Gaussian components. Each component represents a potential mode in the data. Each Gaussian component has its own independent set of parameters, including a mean, a variance, and a mixing coefficient. During initialization, these parameters need to be separately initialized for each Gaussian component. The mean represents a center of the mode, the variance represents a distribution range, and the mixing coefficient represents a weight of the mode. In the E-step, a responsibility of each data point with respect to each component is calculated. In the M-step, only parameters of the corresponding component are updated based on the responsibilities. Finally, each component represents a main mode in the data. A combination of these components may adapt to the overall complex distribution. When a new mode appears, a component may be added for adaptation.

A responsibility change refers to an amount of change in the responsibility of data points with respect to Gaussian components of the Gaussian mixture model during an EM algorithm-based iteration process. In this application, in the E-step, a responsibility of each data point with respect to each Gaussian component is calculated. After the M-step, the model parameters are updated, and the responsibilities also change. An absolute value or a sum of squares of changes in the responsibilities of each data point between two iterations is calculated. When the responsibility change is less than a preset threshold, it indicates that the model parameters tend to be stable, and the iteration may be terminated. A maximum iteration count may also be set to prevent excessive invalid iterations. The responsibility change reflects a parameter convergence state, and may be used as one of iteration termination conditions. The threshold needs to be set by comprehensively considering accuracy and convergence speed. An excessively large change indicates that the model is still being adjusted, and an excessively small change indicates that the model has converged. Finally, convergent model parameters are obtained and used for anomaly detection on the open-circuit voltage.

The number H of components needs to be preset, and indicates the number of Gaussian components included in the Gaussian mixture model. The value of H affects the fitting performance of the model on the dataset. An appropriate range of H, for example, 3 to 10, may be provided based on empirical values or prior knowledge. Alternatively, the H value providing the best fitting performance may be selected through multiple tests. Based on the preset value of H, parameters of a corresponding number of Gaussian components need to be initialized for each Gaussian component. The mean may be randomly initialized, or an initial center may be determined based on statistical analysis. The covariance matrix may be initialized as an identity matrix or an empirical value. The mixing coefficient may be initialized to a uniform distribution or assigned according to a specific proportion. Proper setting of initialization parameters may accelerate model convergence. If improperly set, the initialization parameters may also be automatically adjusted during an iteration process. Alternatively, initial H cluster centers may be obtained by using a clustering method such as a subnets method, and parameters of corresponding Gaussian components may be set based on the cluster centers.

After denoising and normalization preprocessing is performed on the open-circuit voltage data, cleaned input data is obtained. The EM algorithm is performed on the preprocessed dataset to iteratively estimate parameters of the Gaussian mixture model. In the E-step, a responsibility of each data point with respect to each Gaussian component is calculated based on current model parameters. The responsibility reflects a probability that the data point belongs to the Gaussian component. In the M-step: a parameter of each Gaussian component, including a mean, a covariance matrix, and a mixing coefficient, is updated based on the responsibilities calculated in the E-step. By iteratively performing the E-step and the M-step multiple times, the model parameters gradually converge to a local optimal solution. An iteration termination condition may be set, for example, that a maximum iteration count is reached, or that a responsibility change is less than a threshold. Methods such as early stopping may also be used to prevent the model from overfitting. Because each E-step and M-step involves a relatively large amount of computation, vectorization may be used to accelerate calculation. The setting of the initialization parameters may also affect the convergence speed. Parameters of the trained Gaussian mixture model are finally obtained, and used for subsequent open-circuit voltage anomaly detection.

Further, the Gaussian mixture model is expressed as follows: $p \left(y\left|θ\right.\right) = {\sum }_{k = 1}^{K} {α}_{k} ϕ \left(y\left|{θ}_{k}\right.\right) ,$ where *θ =* (*∂*₁,*∂*₂,*∂*₃,*......*,*∂ₖ*; *θ*₁,*θ*₂,*θ*₃,*....,θₖ,*) ; *∂ₖ* is a coefficient and represents a probability of selecting the k^{th} Gaussian distribution, ${\partial }_{k} \geq 0 , {\sum }_{k = 1}^{k} {\partial }_{k} = 1 ; {\sum }_{k = 1}^{k} {\partial }_{k} \left(y\left|{θ}_{k}\right.\right)$ is a Gaussian distribution, and ${θ}_{k} = \left({u}_{k}, {σ}_{k}^{2}\right)$ represents parameters of the k^{th} Gaussian distribution; and $ϕ \left(\left.y\right|{θ}_{k}\right) = \frac{1}{\sqrt{2 {πσ}_{k}}} {e}^{- \frac{{\left(y-{u}_{k}\right)}^{2}}{2 {σ}_{k}^{2}}}$ represents the k^{th} Gaussian distribution model, so as to obtain a probability density distribution of open-circuit voltage data of the battery cell under the Gaussian mixture model.

Further, in the E-step, based on current model parameters, a responsibility *γ̂ⱼₖ* of component k with respect to observed data *yⱼ* is calculated according to the following formula: ${\hat{γ}}_{jk} = \frac{{α}_{k} φ \left({y}_{j}\left|{θ}_{k}\right.\right)}{{\sum }_{k = 1}^{k} {α}_{k} φ \left({y}_{j}\left|{θ}_{k}\right.\right)}$, *j =* 1, 2, *..., N*; *k* =1, 2, ..., *K* , where 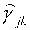 is a probability that the j^{th} piece of observed data comes from the k^{th} component under the current model parameters, and is referred to as the responsibility of the component k with respect to the observed data *yⱼ*. Further, in the M-step, model parameters for a new iteration are calculated as follows: ${\hat{u}}_{k} = \frac{{\sum }_{j = 1}^{N} {\hat{γ}}_{jk} {y}_{j}}{{\sum }_{j = 1}^{N} {{γ}^{⏜}}_{jk}} , k = 1 , 2 , … , k ,$ ${{σ}^{⏜}}_{k}^{2} = \frac{{\sum }_{j = 1}^{N} {\hat{γ}}_{jk} {\left({y}_{j}-{u}_{k}\right)}^{2}}{{\sum }_{j = 1}^{N} {{γ}^{⏜}}_{jk}} , k = 1 , 2 , … , k ,$ and ${{σ}^{⏜}}_{k}^{2} = \frac{{\sum }_{j = 1}^{N} {\hat{γ}}_{jk}}{N} , k = 1 , 2 , … , k ,$ where 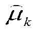 is the mean of the k^{th} component in the new iteration, ${{σ}^{⏜}}_{k}^{2}$ is the variance of the k^{th} component in the new iteration, and 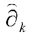 is the mixing coefficient of the k^{th} component in the Gaussian mixture model in the new iteration.

Further, performing anomaly detection on open-circuit voltage data includes: calculating, by using the Gaussian mixture model, a responsibility of the open-circuit voltage of each battery cell in the open-circuit voltage dataset with respect to each Gaussian component; presetting a threshold for determining a responsibility anomaly; and when the responsibilities of a given item of open-circuit voltage data with respect to all Gaussian components are lower than the preset threshold, determining that the piece of open-circuit voltage data is abnormal. Detection is performed on newly collected open-circuit voltage sample data by using the trained Gaussian mixture model. For each item of sample data, a responsibility of the sample data with respect to each Gaussian component of the model is calculated. The responsibility reflects a degree of matching between the data and a known mode, and a higher responsibility indicates a higher matching. A threshold of the responsibility is preset as a determination condition for determining whether an anomaly exists. The responsibility with respect to each Gaussian component is sequentially compared with the threshold. If responsibilities with respect to all Gaussian components are lower than the threshold, it may be determined that the data does not match a known mode and belongs to abnormal data. Determining an anomaly by threshold comparison is simple and intuitive, and a statistical test may also be used. Finally, a data result determined as abnormal is output to locate an abnormal battery cell. An appropriate threshold needs to be determined based on actual conditions. Alternatively, an anomaly may be determined by accumulating probabilities output by the model.

Further, incremental learning is used to adjust the number of components of the Gaussian mixture model and the corresponding Gaussian components. After model training is completed, the model is updated by using an incremental learning method. When the original model cannot properly describe newly appearing data, an incremental learning process is started. The new data is collected and used as an incremental dataset. It is determined whether the new data belongs to an existing Gaussian component or whether a new component needs to be added. If the new data belongs to an existing component, parameters of the other components are fixed, and only parameters of the related component are adjusted to adapt to the new data. If a component needs to be added, parameters of the new component are initialized, and parameters of all components are adjusted simultaneously. The model is iteratively trained based on the new data and the original data by using the EM algorithm, to update the model parameters. The number of components to be added is determined based on complexity of the new data, thereby changing the number of components of the original model. Incremental training is performed repeatedly until the model can properly adapt to the newly added data. Alternatively, when an anomaly occurs, a corresponding component may be removed, and other components are updated to maintain model performance. Incremental learning may enable the model to evolve dynamically and adapt to change in the data distribution. This avoids completely retraining the model each time, thereby improving efficiency.

Further, the number of components of the Gaussian mixture model is adjusted by adding or removing a Gaussian component. After the model training is completed, model performance is monitored to determine whether the number of components needs to be adjusted. If the detection performance is poor and the model fails to fit the data properly, an increase in the number of components may be considered. The number of Gaussian components to be added is determined based on complexity of a newly appearing data mode. A new Gaussian component is added, and a mean, a covariance, and a coefficient of the new Gaussian component are randomly initialized. Parameters of other existing components are fixed, and only parameters of the new component are learned. New mode data is collected, and iteration is performed based on the EM algorithm to learn the parameters of the new component. Parameters of the existing component may also be fine-tuned simultaneously. If an abnormal mode disappears, removal of the corresponding Gaussian component may be considered. Responsibilities assigned to the corresponding Gaussian component are set to 0, and parameters of the other components are adjusted through iterative learning. After the component is removed, the mixing coefficients may need to be renormalized. After the component is removed, performance of the model is checked. If the performance is poor, the original model is restored. Gaussian components are dynamically added or reduced, so that the model size can properly adapt to data complexity.

Further, denoising is performed by median filtering or mean filtering. A raw open-circuit voltage dataset is collected, in which abnormal impulse noise may exist. A sliding window is set, and the window size is usually an odd number, such as 3, 5, or 7. In median filtering, data in a window is sorted in ascending order, and a median value is used as a filtering output, so that impulse noise can be effectively suppressed. In mean filtering, an arithmetic mean value of data in a window is calculated as an output, so that random noise can be suppressed. Filtering is performed on the dataset by using the sliding window to generate a denoised dataset. Median filtering is effective at removing the impulse noise, but is slightly inferior in preserving details. Mean filtering is effective at preserving details, but slightly weak at suppressing the impulse noise. Median filtering or mean filtering may be selected and used according to requirements of an application scenario. Median filtering may be first performed to remove impulse noise, and then mean filtering may be performed to preserve details. A filtering window size is properly set, and is usually an odd number ranging from 3 to 7.

Further, normalization processing includes mapping the open-circuit voltage value to an interval [0, 1] by using a linear normalization function. Original sampled values of the open-circuit voltage are collected, and the original sampled values may have different voltage ranges. A target interval for normalization is set to [0, 1]. The minimum value min and the maximum value max among all sampled data are found. For each sampled data value x, a corresponding y is calculated according to the linear normalization function: y = (x - min)/(max - min), so that x is mapped to the interval [0, 1]. The raw open-circuit voltage data is converted into a uniform range [0, 1] according to the foregoing function. Linear normalization preserves characteristics of the original data distribution and relative magnitudes. Therefore, data in different voltage ranges can be directly compared, facilitating subsequent modeling. Other normalization functions, such as sigmoid function, a tanh function, and the like may be used. The linear function is simple in calculation and provides good normalization performance. Alternatively, different target normalization intervals may be set.

### 3. Beneficial effects

Compared with the prior art, this application has the following advantages:
By using the Gaussian mixture model, the method can more accurately model a distribution of the open-circuit voltage data, thereby improving detection precision. An iterative optimization process of the EM algorithm helps to better fit a complex data distribution, so that the model better conforms to actual conditions.

An incremental learning approach and a strategy of dynamically adjusting the number of components are introduced, so that the model can flexibly adapt to possible changes in the battery system during operation, thereby improving dynamic adaptability of the system.

By calculating responsibilities of the open-circuit voltage data with respect to the Gaussian components, the method can effectively perform anomaly detection. Setting a responsibility threshold helps to accurately determine whether the open-circuit voltage of the battery cell is abnormal, thereby improving robustness of the system.

Median filtering or mean filtering is introduced to perform denoising processing, and a linear normalization function is introduced to perform normalization processing, helping to eliminate interference and inconsistency in the data, and improving robustness of the model under various data conditions.

### BRIEF DESCRIPTION OF THE DRAWINGS

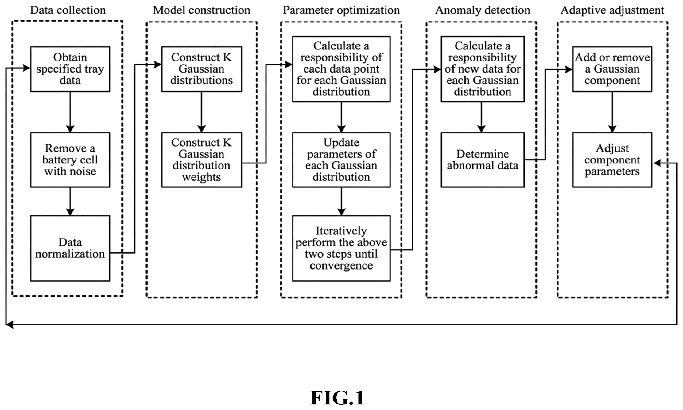

FIG. 1 is a schematic diagram of a method for detecting an open-circuit voltage of a battery cell based on a Gaussian mixture model according to this application.

### DETAILED DESCRIPTION

This application is described below in detail with reference to the accompanying drawings of the specification and specific embodiments.

FIG. 1 is a schematic diagram of a method for detecting an open-circuit voltage of a battery cell based on a Gaussian mixture model according to this application. This application provides a statistical Gaussian mixture model (GMM)-based method for performing anomaly detection on an open-circuit voltage (OCV) of a battery cell. The method can model a complex OCV distribution, accurately distinguish normal samples from abnormal samples, identify different operating modes and fault conditions, and reduce dependency on a large amount of labeled data. The open-circuit voltage of a battery cell is an important health status indicator. However, the OCV usually exhibits a complex statistical distribution, causing difficulty in anomaly detection. In addition, different operating modes and fault conditions may cause changes in the OCV distribution. Existing methods based on thresholds and fixed models usually cannot accurately describe the OCV distribution, resulting in a relatively high false alarm rate. Battery OCV data in a normal operating state is collected, and a Gaussian mixture model is established to describe a probability distribution of the OCV. For newly measured OCV data, a probability score of the newly measured OCV data under the GMM model is calculated. If the score is lower than a threshold, the corresponding OCV data is determined as abnormal. When an anomaly is found, a clustering property of the GMM is used to identify the mode to which the OCV belongs, thereby determining a fault type. GMM parameters are updated online, enabling the GMM to adapt to a change in the OCV distribution. Compared with a fixed model and a threshold method, the GMM can more accurately describe the statistical distribution of the OCV of the battery. Compared with a purely data-driven method, the GMM needs only a small amount of labeled data. The method can be used to detect anomalies, classify and identify different fault conditions, and therefore has strong adaptability.

Tray data is screened. Open-circuit voltage (OCV) data of all battery cells in a specific tray at a capacity grading stage of a specific day is selected. The data records a time, a tray number, and an open-circuit voltage (OCV) value. The open-circuit voltage (OCV) value list of the battery cells is [*x*₁, *x*₂, *x*₃,......, *x_{M}*], where *x*_{M} represents the open-circuit voltage (OCV) value of the M^{th} battery cell.

Preprocessing is performed on the data. First, denoising processing is performed to remove battery cells whose open-circuit voltage (OCV) is higher than a fixed threshold in each tray. Open-circuit voltage (OCV) values of all remaining battery cells are used as detection data, and the open-circuit voltage (OCV) value list of the remaining battery cells is [*x*₁, *x*₂, *x*₃,......, *x_{N}*], where *x*_{N} represents the open-circuit voltage (OCV) value of the N^{th} battery cell, and N ≤ M.

Normalization processing is performed on the data. The data is mapped to an interval [0, 1] by normalization using a linear function, thereby effectively avoiding impact on characteristic weights of different channels caused by different units, dimensions, and the like. A specific formula of the normalization is as follows: ${y}_{j} = \frac{{x}_{j} - {x}_{min}}{{x}_{max} - {x}_{min}} ,$ where yⱼ represents a normalized open-circuit voltage (OCV) value of a battery cell; xⱼ represents any element in a time-sequence dataset [*x*₁, *x*₂, *x*₃,......, *x_{N}*] ; xₘₐₓ and xₘᵢₙ respectively represent the maximum value and the minimum value in each feature sequence; and the normalized open-circuit voltage (OCV) value list of the battery cells is [*y*₁, *y*₂, *y*₃ ,......, *y_{N}*].

The open-circuit voltage data of a battery cell usually exhibits a multimodal mixture distribution, and it is difficult for a single probability distribution model to accurately describe the distribution of the open-circuit voltage data. In this solution, a Gaussian mixture model is used to describe the distribution of the open-circuit voltage data of the battery cell, so that multimodal characteristics of the data can be better reflected. The Gaussian mixture model is a probabilistic generative model that assumes that all data points are generated from a mixture of a plurality of different Gaussian distributions. Formally, the Gaussian mixture model may be expressed as follows: $p \left(y\left|θ\right.\right) = {\sum }_{k = 1}^{K} {α}_{k} ϕ \left(y\left|{θ}_{k}\right.\right) ,$ where *θ =* (*∂₁,* ∂₂, ∂₃, ..... *∂ₖ* ; *θ*₁, *θ*₂, *θ*₃, ...., *θₖ*, ) ; *∂ₖ* is a coefficient and represents a probability of selecting the k^{th} Gaussian distribution, ${\partial }_{k} \geq 0 , {\sum }_{k = 1}^{k} {\partial }_{k} = 1 ; {\sum }_{k = 1}^{k} {\partial }_{k} \left(y\left|{θ}_{k}\right.\right)$is a Gaussian distribution, and ${θ}_{k} = \left({u}_{k}, {σ}_{k}^{2}\right)$ represents parameters of the k^{th} Gaussian distribution; and $ϕ \left(\left.y\right|{θ}_{k}\right) = \frac{1}{\sqrt{2 {πσ}_{k}}} {e}^{- \frac{{\left(y-{u}_{k}\right)}^{2}}{2 {σ}_{k}^{2}}}$ represents the k^{th} Gaussian distribution model, so as to obtain a probability density distribution of the open-circuit voltage data of the battery cell under the Gaussian mixture model. The model is evaluated to ensure that it can accurately describe distribution characteristics of the open-circuit voltage of the battery cell. The multimodal characteristics of the open-circuit voltage distribution of the battery cell are analyzed using the model. The Gaussian mixture model can flexibly describe multimodal distribution characteristics of the open-circuit voltage data of the battery cell. Compared with a single model, the Gaussian mixture model can more accurately describe different modes in the data, thereby providing support for battery cell state analysis and quality prediction.

Algorithm procedure: parameters of Gaussian distributions are initialized. An initial value ∂*ₖ* of a mixing coefficient is a random variable sampled from a uniform Dirichlet distribution; an initial value *uₖ* of a mean is randomly generated from a normal distribution, and a center is determined based on observed data; and an initial value *σₖ* of a standard deviation is determined as a reciprocal of a square root of a vector of random values sampled from an exponential distribution, where parameters of the exponential distribution are determined according to a data analysis technology.

E-step: based on current model parameters, a responsibility *γ̂ⱼₖ* of component k with respect to observed data *yⱼ* is calculated according to the following formula: ${\hat{γ}}_{jk} = \frac{{α}_{k} φ \left({y}_{j}\left|{θ}_{k}\right.\right)}{{\sum }_{k = 1}^{k} {α}_{k} φ \left({y}_{j}\left|{θ}_{k}\right.\right)} , j = 1 , 2 , … , N ; k = 1 , 2 , … , K ,$ where *γ̂ⱼₖ* is a probability that the j^{th} piece of observed data comes from the k^{th} component under the current model parameters, and is referred to as the responsibility of component k with respect to the observed data *yⱼ.*

M-step: model parameters for a new iteration are calculated as follows: ${\hat{u}}_{k} = \frac{{\sum }_{j = 1}^{N} {\hat{γ}}_{jk} {y}_{j}}{{\sum }_{j = 1}^{N} {{γ}^{⏜}}_{jk}} , k = 1 , 2 , … , k ,$ ${{σ}^{⏜}}_{k}^{2} = \frac{{\sum }_{j = 1}^{N} {\hat{γ}}_{jk} {\left({y}_{j}-{u}_{k}\right)}^{2}}{{\sum }_{j = 1}^{N} {{γ}^{⏜}}_{jk}} , k = 1 , 2 , … , k ,$ and ${{σ}^{⏜}}_{k}^{2} = \frac{{\sum }_{j = 1}^{N} {\hat{γ}}_{jk}}{N} , k = 1 , 2 , … , k ,$ where 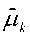 is the mean of the k^{th} component in the new iteration, ${{σ}^{⏜}}_{k}^{2}$ is a variance of the k^{th} component in the new iteration, and 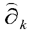 is the mixing coefficient of the k^{th} component in the Gaussian mixture model in the new iteration.

The E-step and the M-step are repeated until convergence. An EM iteration termination threshold is set to 0.001, and a maximum iteration count is set to 100.

Anomaly detection: for newly observed data x, the responsibility of the newly observed data x with respect to each Gaussian component k is calculated as follows: ${\hat{γ}}_{jk} = \frac{{α}_{k} ϕ \left({y}_{j}\left|{θ}_{k}\right.\right)}{{\sum }_{k = 1}^{k} {α}_{k} ϕ \left({y}_{j}\left|{θ}_{k}\right.\right)} , j = 1 , 2 , … , N ; k = 1 , 2 , … , K ,$ where 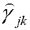 is the probability that the j^{th} piece of observed data comes from the k^{th} component under the current model parameters, and is referred to as the responsibility of component k with respect to the observed data *yⱼ.*

If the values of 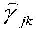 are very small for all k = 1, ..., K, x is determined as abnormal data. To ensure the accuracy and recall rate of anomaly detection, the threshold is set to 0.3.

Adaptive parameter estimation and Gaussian component adjustment: addition of a Gaussian component. When new mode data is observed, model parameters need to be adjusted to adapt to the new mode. The new mode data is used as a new Gaussian distribution, and a mean and a variance are initialized as ${θ}_{k + 1} = \left({u}_{k + 1}, {σ}_{k + 1}^{2}\right)$. Removal of a Gaussian component: if the responsibility of a specific component remains persistently low, the specific component is removed. A new Gaussian mixture model is established by adding the new Gaussian distribution to the original Gaussian mixture model, where the model parameters are *θ =* (∂₁, ∂₂, ∂₃, ..., ∂_{*k+*1}; *θ*₁, *θ*₂,..., *θ*_{*k+*1}) *,* and component parameters are adjusted.

The foregoing procedure is repeatedly performed to continuously perform anomaly detection. The present application and implementations thereof have been schematically described above, and the description is not intended to limit the present application. The present application may be implemented in other specific forms without departing from the spirit or basic characteristics of the present application. The content shown in the accompanying drawings is merely one implementation of the present application, and the actual implementation is not limited thereto. Any reference signs in the claims should not be construed as limiting the corresponding claims. Any similar implementations or embodiments that can be obtained by a person of ordinary skill in the art in view of the teachings of the present application without inventive effort and without departing from the spirit of the present application shall fall within the protection scope of this patent. In addition, the term "comprise" or "include" does not exclude other elements or steps, and the term "a" or "an" before an element does not exclude a plurality of such elements. A plurality of elements stated in product claims may alternatively be implemented by one and the same element through software or hardware. Terms such as "first" and "second" are used only for naming purposes, and do not indicate any particular order.

## Claims

1. A method for detecting an open-circuit voltage of a battery cell based on a Gaussian mixture model, comprising:
collecting an open-circuit voltage dataset that comprises a time stamp, a battery cell number, and an open-circuit voltage value;
performing preprocessing of denoising and normalization on the collected open-circuit voltage dataset;
constructing a Gaussian mixture model using the preprocessed open-circuit voltage dataset based on an expectation-maximization (EM) algorithm; and
performing anomaly detection on an open-circuit voltage using the constructed Gaussian mixture model.

2. The method for detecting an open-circuit voltage of a battery cell based on a Gaussian mixture model according to claim 1, wherein
constructing the Gaussian mixture model comprises:
presetting a number H of components of the Gaussian mixture model, and initializing a mean, a variance, and a mixing coefficient of each Gaussian component i, wherein the number H of components represents a number of Gaussian components comprised in the Gaussian mixture model;
iteratively performing an E-step and an M-step on the preprocessed open-circuit voltage dataset, wherein
in the E-step, a responsibility of each piece of open-circuit voltage data with respect to each Gaussian component i is calculated; and
in the M-step, parameters of each Gaussian component i are updated based on the responsibilities obtained in the E-step; and
setting a threshold of a responsibility change and a maximum iteration count, and repeating the E-step and the M-step until the responsibility change is less than the preset threshold or the preset maximum iteration count is reached.

3. The method for detecting an open-circuit voltage of a battery cell based on a Gaussian mixture model according to claim 2, wherein
the Gaussian mixture model is expressed as follows: $p \left(y\left|θ\right.\right) = {\sum }_{k = 1}^{K} {α}_{k} ϕ \left(y\left|{θ}_{k}\right.\right) ,$ wherein *θ* = (*∂*₁,*∂₂*,∂₃, ......,*∂ₖ*;*θ*₁,*θ*₂,*θ*₃,......,*θₖ*,) ; *∂ₖ* is a coefficient and represents a probability of selecting the k^{th} Gaussian distribution, ${\partial }_{k} \geq 0 , {\sum }_{k = 1}^{k} {\partial }_{k} = 1 ; {\sum }_{k = 1}^{k} {\partial }_{k} \left(y\left|{θ}_{k}\right.\right)$ is a Gaussian distribution, and ${θ}_{k} = \left({u}_{k}, {σ}_{k}^{2}\right)$ represents parameters of the k^{th} Gaussian distribution; and $ϕ \left(\left.y\right|{θ}_{k}\right) = \frac{1}{\sqrt{2 {πσ}_{k}}} {e}^{- \frac{{\left(y-{u}_{k}\right)}^{2}}{2 {σ}_{k}^{2}}}$ represents the k^{th} Gaussian distribution model, so as to obtain a probability density distribution of the open-circuit voltage data of the battery cell under the Gaussian mixture model.

4. The method for detecting an open-circuit voltage of a battery cell based on a Gaussian mixture model according to claim 3, wherein
in the E-step, based on current model parameters, a responsibility *γ̂ⱼₖ* of component k with respect to observed data *yⱼ* is calculated: ${\hat{γ}}_{jk} = \frac{{α}_{k} φ \left({y}_{j}\left|{θ}_{k}\right.\right)}{{\sum }_{k = 1}^{k} {α}_{k} φ \left({y}_{j}\left|{θ}_{k}\right.\right)} , j = 1 , 2 , … , N ; k = 1 , 2 , … , K ,$ wherein 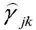 is a probability that a j^{th} piece of observed data comes from a k^{th} component under the current model parameters, and is referred to as the responsibility of the component k with respect to the observed data *yⱼ.*

5. The method for detecting an open-circuit voltage of a battery cell based on a Gaussian mixture model according to claim 4, wherein
in the M-step, model parameters for a new iteration are calculated as follows: ${\hat{u}}_{k} = \frac{{\sum }_{j = 1}^{N} {\hat{γ}}_{jk} {y}_{j}}{{\sum }_{j = 1}^{N} {{γ}^{⏜}}_{jk}} , k = 1 , 2 , … , k ,$ ${{σ}^{⏜}}_{k}^{2} = \frac{{\sum }_{j = 1}^{N} {\hat{γ}}_{jk} {\left({y}_{j}-{u}_{k}\right)}^{2}}{{\sum }_{j = 1}^{N} {{γ}^{⏜}}_{jk}} , k = 1 , 2 , … , k ,$ and ${{σ}^{⏜}}_{k}^{2} = \frac{{\sum }_{j = 1}^{N} {\hat{γ}}_{jk}}{N} , k = 1 , 2 , … , k ,$ wherein 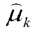 is the mean of the k^{th} component in the new iteration, ${{σ}^{⏜}}_{k}^{2}$ is the variance of the k^{th} component in the new iteration, and 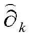 is the mixing coefficient of the k^{th} component in the Gaussian mixture model in the new iteration.

6. The method for detecting an open-circuit voltage of a battery cell based on a Gaussian mixture model according to any one of claims 2 to 5, wherein
performing anomaly detection on the open-circuit voltage data comprises:
calculating, by using the Gaussian mixture model, a responsibility of the open-circuit voltage of each battery cell in the open-circuit voltage dataset with respect to each Gaussian component; presetting a threshold for determining a responsibility anomaly; and
when the responsibilities of a given item of open-circuit voltage data with respect to all Gaussian components are lower than the preset threshold, determining that the given item of open-circuit voltage data is abnormal.

7. The method for detecting an open-circuit voltage of a battery cell based on a Gaussian mixture model according to claim 6, wherein
the number of components of the Gaussian mixture model and corresponding Gaussian components are adjusted by incremental learning.

8. The method for detecting an open-circuit voltage of a battery cell based on a Gaussian mixture model according to claim 7, wherein
adjusting the number of components of the Gaussian mixture model comprises adding or removing a Gaussian component.

9. The method for detecting an open-circuit voltage of a battery cell based on a Gaussian mixture model according to claim 1, wherein
denoising is performed by median filtering or mean filtering.

10. The method for detecting an open-circuit voltage of a battery cell based on a Gaussian mixture model according to claim 9, wherein
normalization is performed by mapping the open-circuit voltage value to an interval [0, 1] using a linear normalization function.
